# EUROPÄISCHE PATENTSCHRIFT

(11) **EP 3 025 136 B1**
(45) Veröffentlichungstag und Bekanntmachung des Hinweises auf die Patenterteilung: **20.09.2017**
(21) Anmeldenummer: 14744817.9
(22) Anmeldetag: 25.07.2014
(51) Int. Cl.: G01M 17/007, G01M 15/02, G06F 17/50

(54) **VERFAHREN ZUR DURCHFÜHRUNG EINES PRÜFLAUFS AUF EINEM PRÜFSTAND**
METHOD FOR CARRYING OUT A TEST RUN ON A TEST STAND
PROCÉDÉ PERMETTANT D'EFFECTUER UNE MARCHE D'ESSAI SUR UN BANC D'ESSAI

(30) Priorität: 26.07.2013 AT 504722013
(43) Veröffentlichungstag der Anmeldung: 01.06.2016
(73) Patentinhaber: AVL List GmbH, 8020 Graz (AT)
(72) Erfinder: PFISTER, Felix, A-8010 Graz (AT); REITZE, Clemens, 76199 Karlsruhe (DE)
(74) Vertreter: Patentanwälte Pinter & Weiss OG
(86) Internationale Anmeldenummer: PCT/EP2014/065996
(87) Internationale Veröffentlichungsnummer: WO 2015/011251

(56) Entgegenhaltungen:
- EP-A1- 2 246 686
- US-A1- 2007 260 372

## Beschreibung

Die gegenständliche Erfindung betrifft ein Verfahren zur Durchführung eines Prüflaufs für ein virtuelles Fahrzeug auf einem Prüfstand.

Prüfläufe für Prüfstandsversuche von Fahrzeugen oder Komponenten davon, wie z.B. Antriebsstrang, Verbrennungsmotor, Getriebe, etc., werden heute zum Teil aus realen Testfahrten ermittelt. Dabei wird eine reale Teststrecke mit einem realen Fahrzeug abgefahren und dabei Messdaten, aber auch die Umgebung der Straße und des Fahrzeugs, wie z.B. Verkehr, etc., und bestimmte Ereignisse, wie z.B. Straßenschilder, Ampeln, Zebrastreifen, etc., erfasst. Über GPS und andere Messtechniken kann das Straßenprofil (Neigung, Steigung, Kurven, etc.), die Fahrzeugoberfläche (Geometrie, Materialeigenschaften, etc.) und auch die dynamischen Daten des Fahrzeugs (Geschwindigkeit, Beschleunigung, Verbrauch, Indizierdaten der Verbrennung eines Verbrennungsmotors, Emissionen, etc.) und der Umgebung (Verkehr, Seitenwind, Temperatur, Druck, Luftfeuchten, etc.) erfasst werden. Gleichermaßen kann dabei auch das Fahrerverhalten, z.B. das Beschleunigungs- und Bremsverhalten, erfasst werden. Aus den erfassten Daten wird eine Simulation erstellt, mit der der Prüfstand angesteuert wird, um auf den Prüfstand die erfasste oder eine davon abgeleitete Teststrecke virtuell abzufahren. Dabei wird in der Regel ein eindimensionales Profil der Form v=v(x) oder v=v(t), mit v= Geschwindigkeit, x= Weg bzw. Bogenlänge der Strasse, t=Zeit, erstellt, das die abgefahrene Strecke charakterisiert und das dann am Prüfstand nachgefahren wird. Z.B. wird ein Rollenprüfstand so angesteuert, dass das darauf angeordnete Fahrzeug die erfasste Teststrecke abfährt. Die Teststrecke kann dabei auch grafisch durch eine Simulation mittels Grafikobjekten visualisiert werden. Ein derartiges System ist z.B. aus der EP 2 246 686 A1 bekannt. Ein anderes System ist aus der US 2007/260372 bekannt. Gleichzeitig können bei den Testfahrten auch Videos oder Audiodaten der abgefahrenen Streck, der Fahreraktivitäten oder des Fahrzeugs und seiner Umgebung aufgezeichnet werden. Die WO 2009/083944 A1 beschreibt z.B. die Erfassung von Messdaten von Sensoren, die an einem Fahrzeug angeordnet sind, wobei dabei über eine Kamera auch Videos der gefahrenen Strecke erfasst und gespeichert werden. Auf die weitere Verwendung dieser Videodaten wird darin aber nicht eingegangen.

Im bekannten Stand der Technik erfolgt die Erfassung, Verwaltung und Darstellung von während einer Testfahrt erfassten Messdaten über eine gemeinsame Zeitachse (also zeitsynchron), eine gemeinsame eindimensionale Wegachse (also wegsynchron) oder über Kurbelwinkelsignal (also winkelsynchron). Diese Art der Verarbeitung birgt allerdings einige Probleme. Zum einen können Messdaten verschiedener Prüfläufe, selbst wenn diesen teilweise (abschnittsweise) die gleiche Teststrecke zugrunde liegt, kaum miteinander verglichen werden, da es fast unmöglich ist, in zeitsynchron (t), wegsynchron (x) oder winkelsynchron verwalteten Daten Überschneidungen zu finden. Zum anderen ist ein Prüflauf, der aus einer realen Testfahrt abgeleitet wurde, niemals vollkommen identisch mit der realen Testfahrt, beispielsweise, weil bei der virtuellen Testfahrt der Fahrer die Kurven anders anschneidet. Doch damit ergibt sich im Prüflauf zwangsweise immer eine zeitliche oder räumliche Divergenz in den Messdaten der realen oder anderer virtueller Testfahrten und in den Messdaten des Prüflaufs. Das macht sich verstärkt bemerkbar, wenn dieselbe Strecke mit unterschiedlichen Fahrerprofilen (Fahrereigenschaften) abgefahren wird. Auch solche Testläufe sind nicht unmittelbar vergleichbar. Das macht in der Praxis erhebliche Schwierigkeiten beim Aufbau vergleichbarer Prüfläufe und beim Vergleich der Messdaten.

Es ist daher eine Aufgabe der gegenständlichen Erfindung, ein Verfahren anzugeben, mit dem es ermöglicht wird, Messergebnisse aus Prüfläufe wesentlich effektiver, schneller und besser aufzubauen und die Messergebnisse daraus "übereinanderzulegen" und zu vergleichen, um so zu aussagekräftigen Ergebnissen eines Prüflaufs zu kommen.

Diese Aufgabe wird erfindungsgemäß dadurch gelöst, indem eine virtuelle Strecke aus einem Datenspeicher eingelesen wird, wobei die virtuelle Strecke als Sequenz von Geokoordinaten und zugehörigen auf die Geokoordinate bezogenen Daten des Fahrzeuges, eines Fahrers und/oder einer Umgebung des Fahrzeugs gespeichert wird, und zur Durchführung des Prüflaufs für das virtuelle Fahrzeug verwendet werden, wobei während des Prüflaufs Messdaten des virtuellen Fahrzeugs erfasst und bezogen auf die Geokoordinaten gespeichert werden. Damit löst man sich vom bisher üblichen eindimensionalen Weg-Zeitprofil mit allen beschrieben Nachteilen, indem alle Daten auf Geokoordinaten bezogen erfasst und gespeichert werden. Die virtuelle Teststrecke liegt nunmehr als dreidimensionale Trajektorie in Form von Geokoordinaten mit dazu hinterlegten Daten vor, die zur Durchführung des Prüflaufs verwendet werden, was es ermöglicht Daten und/oder Messdaten aus dem Prüflauf unmittelbar über die Geokoordinate abzurufen und zu vergleichen.

Die virtuelle Strecke für den Prüflauf lässt sich vorzugsweise durch Abfahren einer realen Strecke mit einem realen Fahrzeug erstellen, indem während der Fahrt entlang der realen Strecke die Geokoordinaten und Daten des Fahrzeuges, des Fahrers und/oder der Umgebung des Fahrzeugs erfasst und als zeitliche Sequenz auf die Geokoordinaten bezogen gespeichert werden. Das ermöglicht insbesondere die automatisierte Erstellung der virtuellen Strecke als zeitliche Sequenz von Geokoordinaten, wobei die virtuelle Strecke sehr nahe an der realen Strecke ist.

Alternativ kann die virtuelle Strecke auch aus digitalen 3D-Kartendaten erfasst werden, wobei Daten des Fahrzeuges, des Fahrers und/oder der Umgebung des Fahrzeugs hinzugefügt werden können.

Ganz besonders vorteilhaft wird der Prüflauf- insbesondere auch die für die Aktoren des Prüfstandes relevanten Größen, wie z.B. Luftdruck, Luftfeuchte, Strassensteigung und Krümmung, etc. - als Sequenz von gespeicherten Geokoordinaten abgefahren. Damit kann der Prüflauf unmittelbar aus der virtuellen Strecke erzeugt werden, indem die gespeicherten Geokoordinaten nacheinander angefahren werden. Weitere für den Prüflauf notwendige Daten können einfach Geokoordinaten bezogen aus dem Datenfile der virtuellen Strecke entnommen werden. Dazu kann vorgesehen sein, dass eine in Bezug auf die Geokoordinaten gespeicherte Geschwindigkeit oder eine gespeicherte Zeit verwendet wird, um im Prüflauf das virtuelle Fahrzeug zu steuern.

Zur Durchführung des Prüflaufs kann das virtuelle Fahrzeug von einem virtuellen Fahrer anhand eines Fahrermodells gesteuert wird. Das ermöglicht es anhand von verschiedenen Fahrermodellen dieselbe virtuelle Strecke auf unterschiedliche Weise abzufahren und verschiedene Messdaten zu erzeugen, die nachher über die Geokoordinaten auch einfach vergleichbar sind. Alternativ kann das virtuelle Fahrzeug zur Durchführung des Prüflaufs auch von einem realen Fahrer gesteuert werden.

Ganz besonders vorteilhaft ist es, wenn zusätzlich Videodaten der Teststrecke in Form einer Sequenz von Videoframes erfasst werden und während des Prüflaufs am Prüfstand derjenige Videoframe ermittelt und dargestellt wird, der der jeweiligen Geokoordinate entspricht. Auf diese Weise können einfach Videos der realen Fahrt am Prüfstand eingespielt werden. Reale Videos werden bisher nicht am Prüfstand zur Visualisierung eines Testlaufs verwendet. Das liegt einerseits daran, dass Videodaten sehr speicherintensiv sind, Videodaten aufwendig in der Verwaltung und Verarbeitung (Schneiden, Konkatenieren, Zeitachse, etc.) sind und die Synchronisation der Videodaten mit dem Prüflauf am Prüfstand schwierig ist. Allerdings wünscht man sich am Prüfstand eine realere Visualisierung der Prüfläufe, was nun anhand der realen Videos und die Verwaltung, Ansteuerung und Synchronisierung der Videoplayer über Geokoordinaten einfach möglich ist.

Auf dieselbe Weise können auch Audiodaten der Teststrecke erfasst und auf die Geokoordinate bezogen gespeichert werden und während des Prüflaufs am Prüfstand diejenigen Audiodaten widergegeben werden, die der jeweiligen Geokoordinate entsprechen.

Wenn während des Prüflaufs Daten oder Messdaten zur jeweiligen Geokoordinate abgerufen und angezeigt werden, kann auf einfache Weise online während der Durchführung des Prüflaufs ein direkter Vergleich mit bereits vorhandenen Daten oder Messdaten erfolgen.

Gleichfalls können im Postprocessing des Prüflaufes Daten oder Messdaten über ihre Geokoordinate gesucht, identifiziert und verglichen werden, was die Nachbearbeitung des Prüflaufs stark vereinfacht.

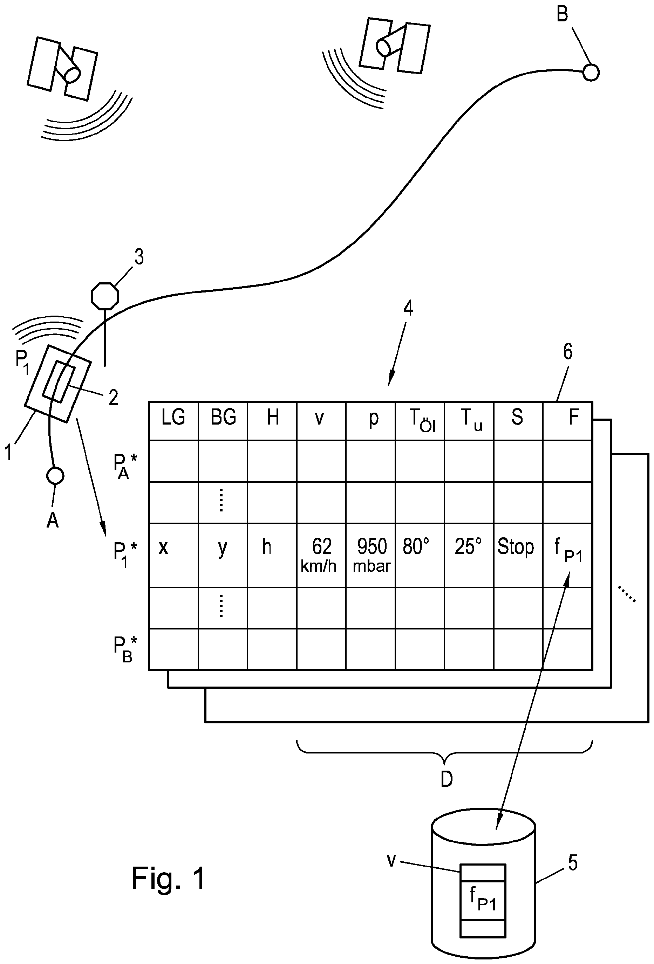

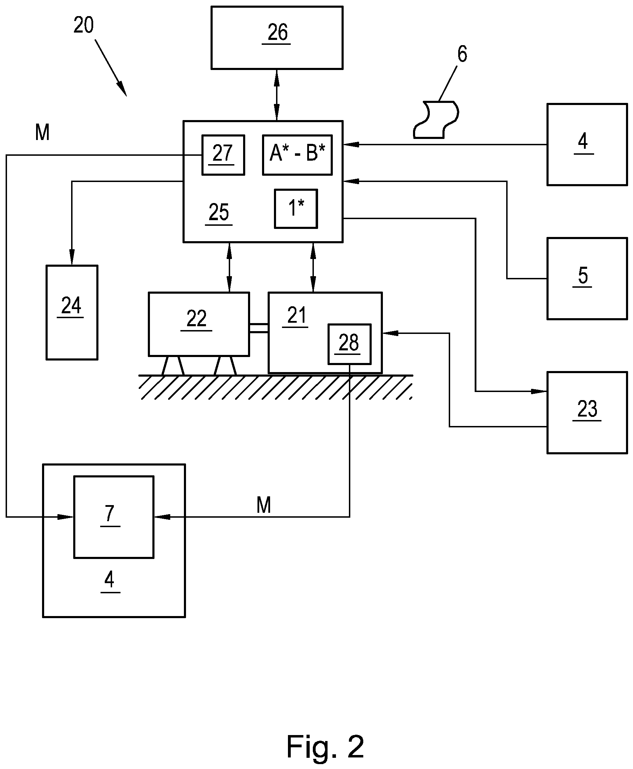

Die gegenständliche Erfindung wird nachfolgend unter Bezugnahme auf die Figuren 1 und 2 näher erläutert, die beispielhaft, schematisch und nicht einschränkend vorteilhafte Ausgestaltungen der Erfindung zeigen. Dabei zeigt
- Fig.1: die Erfassung einer virtuellen Strecke und
- Fig.2: einen Prüfstand zur Durchführung eines Prüflaufs mit einem virtuellen Fahrzeug.

Wie in Fig.1 angedeutet, fährt ein Fahrzeug 1 in einer möglichen Ausgestaltung der Erfindung in Realität eine bestimmte Strecke A-B ab. Am Fahrzeug 1 sind Sensoren 2 angeordnet, wobei zumindest eine bekannte Einrichtung zur Bestimmung der momentanen Zeit (oder einer anderen monoton ansteigenden Größe) und der momentanen geographischen Position, z.B. Global Positioning System (GPS) oder Galileo und zumindest ein weiterer Sensor zur Erfassung eines Parameters des Fahrzeugs (Geschwindigkeit, Beschleunigung, Verbrauch, Indizierdaten der Verbrennung eines Verbrennungsmotors, Emissionen, 3D-Orientierung des Fahrzeugs im Raum, etc.), des Fahrers (Beschleunigungs- oder Bremsverhalten, Schaltverhalten, Überholverhalten, etc.) oder der Umgebung (Video, Geräusch, Verkehr, Seitenwind, Temperatur, Druck, Luftfeuchten, Straßenbedingungen, etc.) vorgesehen ist. Solche Sensoren 2 sind hinlänglich bekannt und in vielfältigsten Ausführungen erhältlich und es wird daher hier nicht näher darauf eingegangen. Ebenso ist es denkbar, dass während der Fahrt weitere Ereignisse, wie z.B. ein Straßenschild 3, eine Ampel, Querverkehr, andere Verkehrsteilnehmer, etc., erfasst werden. Die derart während der Fahrt des Fahrzeugs 1 erfassten Daten D werden bezogen auf die geographische Position in einem Datenspeicher 4 abgelegt. Eine derart erfasste, nun virtuelle Strecke A*-B*, bzw. das daraus erzeugte Datenfile 6, kann nachträglich noch bearbeitet werden, z.B. um Daten D, wie Straßenbedingungen (Eis, Schlaglöcher, Straßenbreite, Spurrillen, etc.), Verkehrsschilder, Ampeln, etc. hinzuzufügen oder zu ändern, oder um nicht benötigte Daten D zu entfernen.

Aufgrund von unvermeidbaren Messungenauigkeiten oder möglichen Nachbearbeitungen wird die erfasste Strecke A*-B* nicht exakt der realen Strecke A-B entsprechen, weshalb hier von einer virtuellen Strecke A*-B* gesprochen wird, die mit "*" gekennzeichnet wird.

In weiterer Folge wird eine geographische Position auch vereinfacht als Geokoordinate P bezeichnet. Eine Geokoordinate P ist in diesem Sinne eine eindeutige Angabe einer beliebigen Position auf der Erde, z.B. in Form des Längengrades, des Breitengrades und der Höhe bei GPS.

In einer alternativen Ausgestaltung kann eine reale Strecke A-B in Form von Geokoordinaten P aber auch aus verfügbaren digitalen 3D-Karten extrahiert und daraus eine virtuelle Strecke A*-B* erfasst werden, wobei die anderen Größen, wie Zeit und Parameter des Fahrzeugs oder der Umgebung, entweder ebenfalls aus 3D-Kartendaten entnommen werden können (wie z.B. Straßenschilder) oder nachträglich hinzugefügt werden können.

Die Geokoordinate P wird z.B. nach einem vorgegebenen Zeitraster erfasst, z.B. alle halbe Sekunde, in Form des Längengrades LG, des Breitengrades BG und der Höhe H. Dazu werden jeweils die zusätzlich erfassten Daten abgelegt bzw. hinzugefügt, wie z.B. die Momentangeschwindigkeit v, der Luftdruck p, die Öltemperatur T_{öl}, die Umgebungstemperatur T_{U} oder allfällige Verkehrsschilder S. Grundsätzlich können hier beliebige Daten des Fahrzeugs 1 des Fahres und/oder der Umgebung abgelegt werden, die hier nicht allesamt wiedergegeben werden können. Entscheidend dabei ist, dass die zusätzlichen Daten allesamt ebenfalls bezogen auf eine Geokoordinate P erfasst und abgespeichert werden.

Zusätzlich kann die Fahrt des Fahrzeugs 1 als Video V aufgezeichnet werden. Dabei kann nicht nur die Umgebung aufgezeichnet werden, sondern z.B. auch Bauteile am Fahrzeug 1, wie z.B. das Fahrwerk oder die Bremsen. Im Datenspeicher 4 kann dazu zu jeder Geokoordinate P eine Referenz F auf das aufgezeichnete Video V abgespeichert werden, z.B. in Form der Videoframenummer f_{P1} oder der Videozeit zur jeweiligen Geokoordinate P. Das aufgezeichnete Video V wird dabei in einem Videospeicher 5 gespeichert. Das ist in Fig.1 für die Geokoordinate P₁^{*} angedeutet.

Auch im Falle von aus digitalen Karten abgeleiteten virtuellen Strecken A*-B* können Videos V Geokoordinaten P bezogen erfasst und gespeichert werden. Hierzu kann man verfügbare Videos V zur Strecke A-B oder Teilen davon laden und abspeichern. Z.B. könnte eine Strecke in Google-Earth® abgefahren werden und das erzeugte Videofile als Video für die virtuelle Strecke A*-B* verwendet werden.

Auf diese Weise können auf Geokoordinaten P bezogene Datenfiles von verschiedensten Strecken und unter verschiedensten Bedingungen, wie z.B. verschiedene Jahreszeiten, verschiedene Wetterbedingungen, verschiedene Fahrer, unterschiedlicher Verkehr, etc., erzeugt und abgespeichert werden, wie in Fig.1 angedeutet. Diese derart erzeugten Datenfiles 6 können dann online (auch in Echtzeit) oder offline abgerufen werden.

Dabei können aus mehreren Datenfiles 6 zu verschiedenen Strecken auch neue Strecken, und damit neue Datenfiles 6, erzeugt werden, z.B. indem zwei Strecken an übereinstimmenden geographischen Positionen verbunden werden. Ebenso kann eine Strecke durch Abschneiden eines bestimmten Teiles auch gekürzt werden. Das erfolgt bevorzugt im Rahmen einer offline Datenaufbereitung.

Ein solches auf Geokoordinaten P bezogenes Datenfile 6 einer virtuellen Strecke A*-B* kann nun auf einem Prüfstand 20, z.B. einem Rollenprüfstand für ein Fahrzeug, einem Antriebsstrangprüfstand, oder einem Motorprüfstand, während eines Prüflaufs für ein virtuelles Fahrzeug 1* oder einer Komponente (Antriebsstrang, Verbrennungsmotor, Getriebe, etc.) davon auf verschiedenste Weise genutzt werden, wie mit Bezugnahme auf die Fig.2 näher erläutert wird. Hierbei ist zu beachten, dass unter Prüfstand 20 sowohl Systeme verstanden werden, bei denen der Prüfling 21 (die zu testende Einheit), z.B. Fahrzeug, Antriebsstrang, Batterie, Verbrennungsmotor, etc., real auf einem Prüfstand vorhanden ist und real betrieben wird, aber auch solche, wo der Prüfling 21 selbst ebenfalls nicht real vorhanden ist und anhand von geeigneten Simulationsmodellen 27 simuliert wird.

In erster Linie wird eine solche aufgezeichnete, oder aufbereitete, Testfahrt mit einem Fahrzeug 1, also eine virtuelle Strecke A*-B*, verwendet, um einen Prüflauf auf einem Prüfstand 20 für ein virtuelles Fahrzeug 1* zu steuern, wie unter Bezugnahme auf die Fig.2 näher erläutert wird.

Virtuelles Fahrzeug 1* deshalb, weil das Fahrzeug für den Prüflauf teilweise, oder vollständig, simuliert und teilweise real (in Form des Prüflings 21) aufgebaut ist. Das virtuelle Fahrzeug 1*, muss auch nicht mit dem Fahrzeug 1, mit dem die reale Strecke A-B abgefahren wurde, übereinstimmen. Das virtuelle Fahrzeug 1* besteht aus verschiedenen Komponenten, wie Batterie, Verbrennungsmotor, Elektromotor, Getriebe, Fahrwerk, Reifen, Lenksystem, Bremsen, etc., die anhand von geeigneten Simulationsmodellen 27, z.B. in der Prüfstandsteuereinheit 25, simuliert werden oder am Prüfstand 20 als Prüfling 21 real vorhanden sein können. Z.B. kann die Batterie als Prüfling 21 real vorhanden sein und man spricht dann von Battery-in-the-Loop (allgemein Hardware-in-the-Loop). Der Prüflauf wird dabei auf das virtuelle Fahrzeug 1*, bestehend aus virtuellen und gegebenenfalls realen Komponenten, angewendet.

Unter Prüflauf versteht man dabei das virtuelle Fahrzeug 1*, mit realem oder virtuellem Prüfling 21, auf einem Prüfstand 20, z.B. ein Rollenprüfstand, ein Antriebsstrangprüfstand oder ein Motorprüfstand, einer zeitlichen Abfolge von verschiedenen Fahrzuständen zu unterwerfen und dabei bestimmte gewünschte Messgrößen des virtuellen Fahrzeugs 1* (bzw. des Prüflings 21) zu erfassen und bedarfsweise auszuwerten. Dazu ist in der Regel eine Belastungsmaschine 22 vorgesehen, um verschiedene Belastungszustände, z.B. Steigungen, Beschleunigen, elektrische Leistung, elektrischer Strom, etc., des Prüflings 21 zu simulieren und den Prüfling 21 damit zu belasten. Ist der Prüfling 21 selbst nur virtuell vorhanden, kann die Belastungsmaschine 22 natürlich auch entfallen oder ebenfalls simuliert sein.

Ebenso können am Prüfstand 20 Konditioniersysteme 23 vorgesehen sein, um bestimmte Medien, z.B. Öl, Wasser, Luft, etc., für einen Prüflauf zu konditionieren. Auch können am Prüfstand 20 Klimasysteme 24 vorgesehen sein, um am Prüfstand 20 bestimmte Umgebungsbedingungen, wie z.B. Temperatur, Druck, Wetter, etc., zu simulieren. Durch den Prüflauf wird die erfasste virtuelle Strecke A*-B* nachgefahren. Dazu ist eine Prüfstandsteuereinheit 25 vorgesehen, die alle Komponenten des Prüfstandes 20 gemäß dem Prüflauf steuert.

Die Prüfstandsteuereinheit 25 erhält dazu das Datenfile 6 für eine virtuelle Strecke A*-B*, in dem der Prüflauf auf Geokoordinaten P bezogen, also in Bezug auf eine geographische Koordinate, abgespeichert ist, und kann daraus in Echtzeit eine Sollwertvorgabe für die Komponenten des Prüfstandes 20 erzeugen. Die Positionsdaten, wie Längengrad LG, Breitengrad BG und Höhe H, sowie die dynamischen Daten des Fahrzeugs 1, wie Geschwindigkeit, Beschleunigung, Neigung, werden dazu in Sollwertvorgaben für den Prüfling 21 und die Belastungsmaschine(n) 22, bzw. für andere benötigte Aktuatoren am Prüfstand 20, umgerechnet.

Dazu kann z.B. die im Datenfile 6 der virtuellen Strecke A+-B* gespeicherte Geschwindigkeit v des virtuellen Fahrzeugs 1* entlang der virtuellen Strecke A*-B* über die Zeitachse verwendet werden, um den Prüfling 21 zu steuern. Die Geschwindigkeit v kann dazu auch die Zeit, die zwischen zwei Geokoordinaten P verstreichen muss, festlegen. Alternativ kann auch die gespeicherte Zeit zusammen mit der Distanz zwischen zwei Geokoordinaten P verwendet werden, um eine Geschwindigkeit zu berechnen. Gespeicherte Daten wie 3D-Orientierung des Fahrzeugs 1, Topographie der Strecke (Steigungen, Gefälle, Neigungen) können verwendet werden, um die Belastungsmaschine 22 zu steuern oder um dem Prüfling 21 einen Belastungszustand vorzugeben. Für den Prüflauf wird dann in das virtuelle Fahrzeug 1* noch ein virtueller oder realer Fahrer "gesetzt".

Im Falle eines realen Fahrers steuert dieser das virtuelle Fahrzeug 1* gemäß den Vorgaben (Topographie, Straßenschilder, Geschwindigkeitsbegrenzungen, Ampeln, Ereignisse, etc.) der virtuellen Strecke A*-B* im Datenfile 6.

Im Falle eines virtuellen Fahrers sorgt ein implementiertes Fahrermodell für die Umsetzung der Vorgaben im Datenfile 6. Das Fahrermodell kann sich dabei aus einer Kurs- und Geschwindigkeitsplanung, z.B. um festzulegen, wie Kurven gefahren werden, wie beschleunigt/gebremst wird, wie auf Verkehr auf der Strecke A*-B* reagiert wird, wie auf Ereignisse (z.B. platzender Reifen, Eis auf der Fahrbahn, Elche auf der Fahrbahn, usw.) etc., und aus einer Fahrzeugsteuerung, z.B. zum Betätigen von Gas, Bremse, Kupplung, Gang, Handbremse, Lenkrad, Zündschlüssel, etc., zusammensetzen. Das Fahrermodell kann dabei in seinen Fahreigenschaften, wie defensiv, aggressiv, normal, ökonomisch, parametrierbar sein. Der virtuelle Fahrer sorgt dabei gemäß dem Fahrermodell und der virtuellen Strecke A*-B* für die Umsetzung der für das virtuelle Fahrzeug 1* vorgegebenen Streckenführung und Geschwindigkeiten, z.B. durch Betätigen des Gaspedals oder Bremspedals, durch Hoch- oder Zurückschalten des Getriebes, durch Lenken, etc.

Auf diese Weise kann die virtuelle Strecke A*-B* mit dem virtuellen Fahrzeug 1* in Echtzeit am Prüfstand 20 abgefahren werden. Die Strecke ist dabei nicht mehr als eindimensionales Weg-Zeitdiagramm wie im bekannten Stand der Technik vorhanden, sondern als dreidimensionale Trajektorie in Form von Geokoordinaten P mit dazu hinterlegten Daten D.

Im Datenfile 6 gespeicherte Daten D der Fahrzeugumgebung, wie Umgebungstemperatur, Druck, Wetter, etc., können dem Klimasystem 24 als Sollwertvorgabe übergeben werden. Im Datenfile 6 gespeicherte Daten D, die das Betriebsverhalten des Fahrzeuges wiedergeben, wie Öldruck, Öltemperatur, Wassertemperatur, etc., können einem Konditioniersystem 23 als Sollwertvorgaben vorgegeben werden.

Singularitäten in der virtuellen Strecke A*-B*, wie z.B. eine Brückenüberfahrt, eine Kreuzung oder eine Autobahnauf- oder -abfahrt, können dabei durch geeignete Abarbeitungslogiken gelöst werden, z.B. indem die Höhendaten verglichen werden oder indem die Bewegungsrichtung des virtuellen Fahrzeugs 1*, die aus den Geokoordinaten P ermittelt werden kann, oder im Datenfile 6 direkt abgespeichert sein kann, berücksichtigt wird.

Um der Trägheit von gewissen Komponenten des Prüfstandes 20, z.B. eines Klimasystems 24 oder eines Konditioniersystems 23, Rechnung zu tragen, ist es auch denkbar, dass die Prüfstandsteuereinheit 25 im Datenfile 6 zeitlich, z.B. 10 Sekunden oder 100m, voraus schaut, um allfällige notwendige Sollwertänderungen dieser Komponenten in einer Art Vorsteuerung rechtzeitig zu veranlassen.

Während des Prüflaufs erfasste Messdaten M des virtuellen Fahrzeugs 1*, wie z.B. Indizierdaten der Verbrennung eines Verbrennungsmotors, Verbrauchswerte, Emissionswerte, etc., werden dabei ebenfalls wieder bezogen auf die jeweilige Geokoordinate P in einem Datenspeicher 4 abgespeichert werden. Zur Erfassung von Messdaten M können an realen Komponenten des virtuellen Fahrzeugs, z.B. am Prüfling 21, entsprechende Messsensoren 28 vorgesehen sein, oder es können auch berechnete Größen aus einem Simulationsmodell 27 einer virtuellen Fahrzeugkomponente als Messdaten M verwendet werden. Die Speicherung kann im Datenfile 6, oder in einem eigenen Messdatenfile 7 erfolgen. Über die Geokoordinate P sind Daten D im Datenfile 6 und Messdaten M eindeutig zuordenbar. Messdaten M unterschiedlicher Prüfläufe können so über die Geokoordinate P auch unmittelbar verglichen werden.

Dabei sind am Prüfstand 20 natürlich auch beliebige Variationen denkbar. Z.B. könnte eine aufgezeichnete Testfahrt (virtuelle Strecke A*-B*) am Prüfstand 20 mit einem unterschiedlichen oder mehreren Fahrer(n) mit unterschiedlichem Fahrverhalten virtuell nachgefahren werden oder es könnte ein anderes Wetter simuliert werden. Ebenso könnte die aufgezeichnete Testfahrt am Prüfstand 20 abschnittsweise oder zur Gänze mit einer anderen Geschwindigkeit des Fahrzeugs 1 virtuell nachgefahren werden. Auch die Betriebszustände des Fahrzeugs könnten bewusst verändert werden, um bestimmte Situationen zu testen, z.B. der Ladezustand der Traktionsbatterie eines Hybridfahrzeugs. Diese Änderungen können durch Adaption des Datenfiles 6 erzeugt werden. Diese Variationen sind dabei aber auch in Echtzeit möglich, z.B. indem ein Prüfstandsfahrer über eine I/O-Schnittstelle 26 in den Prüflauf eingreift, z.B. indem er manuell Gas gibt oder bestimmte Parameter verändert.

Das abgespeicherte Videofile V kann beispielsweise verwendet werden, um zu einem Prüflauf, der auf einer abgefahrenen Strecke A-B beruht, zumindest abschnittsweise das Video der realen Fahrt, also der Strecke A-B, einzuspielen und auf einem Bildschirm darzustellen. Dazu wird das Abspielen des Videos V über die abgespeicherte Videoreferenz F mit der jeweiligen Geokoordinate P synchronisiert. Damit ist es möglich, dass zu einer Geokoordinate P immer der passende Videoframe f_{P}, also der Videoframe f_{P}, der der jeweiligen aktuellen Geokoordinate P des virtuellen Fahrzeugs 1* am nächsten ist, dargestellt wird, egal wie und in welcher Sequenz die virtuelle Strecke A*-B* virtuell nachgefahren wird. Die Synchronisierung des Videos V mit dem Prüflauf kann damit sehr einfach über die Geokoordinate P erfolgen. Zwischen zwei abgespeicherten geographischen Positionen läuft das Video einfach weiter, z.B. indem anhand der gespeicherten Zeiten oder Geschwindigkeiten zwischen zwei Geokoordinaten P interpoliert wird. Alternativ könnte auch ein Videoregler implementiert sein, der die Abspielgeschwindigkeit des Videos zwischen zwei Geokoordinaten P regelt. Die zwischen zwei Geokoordinaten P liegenden Videoframes werden daher zeitlich richtig und mit der Geokoordinate P synchronisiert abgespielt. Gibt ein Prüfstandsfahrer z.B. manuell Gas, womit sich das virtuelle Fahrzeug 1* schneller durch die virtuelle Welt bewegt, wird synchron dazu auch das Video V schneller abgespielt. Ganz egal wie der Prüflauf durchgeführt wird, z.B. schneller, langsamer, mit Stops, etc., wird durch die Synchronisierung über die Geokoordinaten P immer die richtige Stelle des Videos V angezeigt.

Finden sich zu einer bestimmten Geokoordinate P mehrere Videos V im Videospeicher, kann dem Prüfstandsfahrer, z.B. von der Prüfstandsteuereinheit 25 über die I/O-Schnittstelle 26, auch eine Auswahl zur Wahl eines bestimmten Videos V angeboten werden. Während einer virtuellen Fahrt entlang der virtuellen Strecke A*-B* sucht eine im Hintergrund laufende Videosuchmaschine laufend in den vorhandenen Videofiles nach Videos V, die im Bereich der jeweiligen Geokoordinate P gedreht wurden und bietet diese dem Prüfstandsfahrer zur Auswahl an. Damit entfällt das umständliche manuelle Suche in den umfangreichen Videofiles. Das kann nicht nur beim Start der virtuellen Fahrt erfolgen, sondern auch laufend während der Fahrt.

Die Videosuchmaschine sorgt dabei auch dafür, dass für eine virtuelle Strecke A*-B* mehrere, separat gespeicherte Videos V an der richtigen Stelle (Geokoordinate P), vorzugsweise automatisiert, gestartet, gestoppt, zusammengefügt oder abgeschnitten werden.

Auf gleiche Weise können natürlich auch aufgezeichnete Audiodaten und alle anderen Messkanäle (Daten D oder Messdaten M des Fahrzeugs 1*, des Fahrers, der Umgebung) verwaltet und während des Prüflaufs am Prüfstand 20 abgespielt, eingespielt oder angezeigt werden.

Ein Video V kann aber auch als Vorgabe für einen Prüfstandsfahrer verwendet werden, indem dieser das Video V vorgespielt bekommt und die darauf vorgespielte Strecke mit geeigneten Steuereinrichtungen, wie z.B. ein Gas- und Bremspedal, manuell nachfährt.

Zu einer virtuell abzufahrenden Strecke A+-B* können in Echtzeit auch Daten D aus Datenfiles 6 oder Messdaten M aus Messdatenfiles 7 anderer erfasster Fahrten angezeigt werden. Dazu wird im Datenspeicher 4 nach Datenfiles 6 oder Messdatenfiles 7 gesucht, die zu den gleichen Geokoordinaten P abgelegt wurden. Damit können Daten D oder Messdaten M zu gleichen Geokoordinaten P, aber unterschiedlichen Testfahrten auch unmittelbar verglichen werden. Das kann z.B. für die Kalibrierung von Steuereinheiten des Fahrzeuges 1 nützlich sein, da man auf diese Weise die Auswirkungen von Änderungen, z.B. auf die Emissionen des Fahrzeugs 1, direkt verfolgen kann.

Derart erzeugte Datenfiles 6 oder Messdatenfiles 7 können natürlich auch im Rahmen eines Postprocessings offline analysiert werden. Beispielsweise können bestimmte Vergleiche durchgeführt werden, indem Daten D oder Messdaten M nach bestimmten Vorgaben, z.B. Fahrt mit Geschwindigkeit 50km/h im 3.Gang, gefiltert und angezeigt werden. Oder es könnte der Verbrauch oder die Emissionen aller Fahrzeuge auf einer gewissen Strecke A-B analysiert werden.

Selbstverständlich können über eine bestimmte Geokoordinate P auch sehr einfach alle dazu gespeicherten Daten D, Messdaten M oder Videos V angezeigt werden.

Zusätzlich könnten entlang der virtuellen Strecke A*-B* auch noch andere Metadaten Geokoordinaten P bezogen abgespeichert werden, wie z.B. Photos, Algorithmen zur Beschaltung von Ampelanlagen, Verkehrsdichte, etc.

## Patentansprüche

1. Verfahren zur Durchführung eines Prüflaufs für ein virtuelles Fahrzeug (1*) auf einem Prüfstand (20) mit den folgenden Verfahrensschritten
- Einlesen einer virtuellen Strecke (A*-B*) aus einem Datenspeicher (4), wobei die virtuelle Strecke (A*-B*) als Sequenz von Geokoordinaten (P) und zugehörigen auf die Geokoordinate (P) bezogenen Daten (D) des Fahrzeuges (1*), eines Fahrers und/oder einer Umgebung des Fahrzeugs (1*) gespeichert ist,
- Verwendung der auf die Geokoordinaten (P) bezogenen gespeicherten Daten (D) zur Durchführung des Prüflaufs für das virtuelle Fahrzeug (1*), **dadurch gekennzeichnet** mit den folgenden Verfahrensschritten
- Erfassen von Messdaten (M) des virtuellen Fahrzeugs (1*) während des Prüflaufs und Speichern der erfassten Messdaten (M) bezogen auf die Geokoordinaten (P).

2. Verfahren nach Anspruch 1, **dadurch gekennzeichnet, dass** eine reale Strecke (A-B) mit einem realen Fahrzeug (1) abgefahren wird und während der Fahrt entlang der realen Strecke (A-B) die Geokoordinaten (P) und Daten (D) des Fahrzeuges (1), des Fahrers und/oder der Umgebung des Fahrzeugs (1) erfasst und als virtuelle Strecke (A*-B*) auf die Geokoordinaten (P) bezogen gespeichert werden.

3. Verfahren nach Anspruch 1, **dadurch gekennzeichnet, dass** aus digitalen 3D-Kartendaten die Geokoordinaten (P) einer Strecke (A-B) erfasst und als virtuelle Strecke (A*-B*) gespeichert werden und Daten (D) des Fahrzeuges (1*), des Fahrers und/oder der Umgebung des Fahrzeugs (1*) hinzugefügt werden.

4. Verfahren nach einem der Ansprüche 1 bis 3, **dadurch gekennzeichnet, dass** als Prüflauf eine Sequenz von gespeicherten Geokoordinaten (P) abgefahren wird.

5. Verfahren nach einem der Ansprüche 1 bis 4, **dadurch gekennzeichnet, dass** eine gespeicherte Geschwindigkeit (v) oder eine gespeicherte Zeit verwendet wird, um im Prüflauf das virtuelle Fahrzeug (1*) zu steuern.

6. Verfahren nach einem der Ansprüche 1 bis 5, **dadurch gekennzeichnet, dass** das virtuelle Fahrzeug (1*) zur Durchführung des Prüflaufs von einem virtuellen Fahrer anhand eines Fahrermodells gesteuert wird.

7. Verfahren nach einem der Ansprüche 1 bis 5, **dadurch gekennzeichnet, dass** das virtuelle Fahrzeug (1*) zur Durchführung des Prüflaufs von einem realen Fahrer gesteuert wird.

8. Verfahren nach Anspruch 1, **dadurch gekennzeichnet, dass** zusätzlich Videodaten der Strecke (A-B) in Form einer Sequenz von Videoframes (f) erfasst werden und während des Prüflaufs am Prüfstand (20) derjenige Videoframe (f_{P}) ermittelt und dargestellt wird, der der jeweiligen Geokoordinate (P) entspricht.

9. Verfahren nach Anspruch 1, **dadurch gekennzeichnet, dass** zusätzlich Audiodaten der Strecke (A-B) erfasst und auf die Geokoordinate bezogen gespeichert werden und während des Prüflaufs am Prüfstand (20) diejenigen Audiodaten widergegeben werden, die der jeweiligen Geokoordinate (P) entsprechen.

10. Verfahren nach Anspruch 1, **dadurch gekennzeichnet, dass** während des Prüflaufs verfügbare Daten (D) oder verfügbare Messdaten (M) zur jeweiligen Geokoordinate (P) abgerufen und angezeigt werden.

11. Verfahren nach Anspruch 1, **dadurch gekennzeichnet, dass** im Postprocessing des Prüflaufes Daten (D) oder Messdaten (M) über ihre Geokoordinate (P) gesucht, identifiziert und verglichen werden.

## Claims

1. A method for carrying out a test run for a virtual vehicle (1*) on a test bench (20), the method comprising the following steps:
- reading a virtual track (A*-B*) from a data storage (4), wherein the virtual track (A*-B*) is stored as a sequence of geo-coordinates (P) and associated data (D) of the vehicle (1*), a driver and/or surroundings of the vehicle (1*), the data (D) being related to the geo-coordinate (P);
- using the stored data (D) related to the geo-coordinate (P) in order to carry out the test run for the virtual vehicle (1*), **characterized by** the following method steps
- detecting measured data (M) of the virtual vehicle (1*) during the test run and storing the detected measured data (M) with reference to the geo-coordinates (P).

2. The method according to claim 1, **characterized in that** a real track (A-B) is driven with a real vehicle (1), and the geo-coordinates (P) and data (D) of the vehicle (1), the driver and/or the surroundings of the vehicle (1) are acquired during the drive along the real track (A-B) and stored as the virtual track (A*-B*) with reference to the geo-coordinates (P).

3. The method according to claim 1, **characterized in that** the geo-coordinates (P) of a track (A-B) are detected from digital 3D map data and stored as the virtual track (A*-B*), and data (D) of the vehicle (1*), the driver and/or the surroundings of the vehicle (1*) is added.

4. The method according to any of claims 1 to 3, **characterized in that the** test run is carried out as sequence of stored geo-coordinates (P).

5. The method according to any of claims 1 to 4, **characterized in that** a stored speed (v) or a stored time is used in order to control the virtual vehicle (1*) in the test run.

6. The method according to any of claims 1 to 5, **characterized in that** the virtual vehicle (1*) for carrying out the test run is controlled by a virtual driver on the basis of a driver model.

7. The method according to any of claims 1 to 5, **characterized in that** the virtual vehicle (1*) for carrying out the test run is controlled by a real driver.

8. The method according to claim 1, **characterized in that** video data about the test track (A-B) is additionally acquired in the form of a sequence of video frames (f) and the video frame (f_{P}) that corresponds to the respective geo-coordinate (P) being determined and displayed during the test run on the test bench (20).

9. The method according to claim 1, **characterized in that** audio data about the test track (A-B) is additionally acquired and stored with reference to the geo-coordinate (P) and the audio data that corresponds to the respective geo-coordinate (P) being played back during the test run on the test bench (20).

10. The method according to claim 1, **characterized in that** available data (D) or available measured data (M) for the respective geo-coordinate (P) is retrieved and displayed during the test run.

11. The method according to claim 1, **characterized in that** data (D) or measured data (M) is searched, identified, and compared via its geo-coordinate (P) in the post-processing of the test run.

## Revendications

1. Procédé de réalisation d'une marche d'essai pour un véhicule virtuel (1*) sur un banc d'essai (20) avec les étapes de procédé suivantes :
- lecture d'un parcours virtuel (A*-B*) à partir d'une mémoire de données (4), dans lequel le parcours virtuel (A*-B*) est mémorisé sous la forme d'une séquence de coordonnées géographiques (P) et de données afférentes (D) rapportées aux coordonnées géographiques (P) du véhicule (1*), d'un chauffeur et/ou d'un environnement du véhicule (1*),
- utilisation des données mémorisées (D) rapportées aux coordonnées géographiques (P) pour réaliser la marche d'essai pour le véhicule virtuel (1*), **caractérisé par** les étapes de procédé suivantes :
- saisie de données de mesure (M) du véhicule virtuel (1*) au cours de la marche d'essai et mémorisation des données de mesure saisies (M) en rapport avec les coordonnées géographiques (P).

2. Procédé selon la revendication 1, **caractérisé en ce qu'**un parcours réel (A-B) est effectué avec un véhicule réel (1) et , au cours du trajet le long du parcours réel (A-B), les coordonnées géographiques (P) et les données (D) du véhicule (1), du chauffeur et/ou de l'environnement du véhicule (1) sont saisies et sont mémorisées comme parcours virtuel (A*-B*) en rapport avec les coordonnées géographiques (P).

3. Procédé selon la revendication 1, **caractérisé en ce que**, à partir de données cartographiques 3D numériques, les coordonnées géographiques (P) d'un parcours (A-B) sont saisies et mémorisées comme parcours virtuel (A*-B*) et les données (D) du véhicule (1*), du chauffeur et/ou de l'environnement du véhicule (1*) sont ajoutées.

4. Procédé selon l'une quelconque des revendications 1 à 3, **caractérisé en ce qu'**une séquence de coordonnées géographiques mémorisées (P) est parcourue comme marche d'essai.

5. Procédé selon l'une quelconque des revendications 1 à 4, **caractérisé en ce que** l'on utilise une vitesse mémorisée (v) ou un temps mémorisé pour commander le véhicule virtuel (1*) dans la marche d'essai.

6. Procédé selon l'une quelconque des revendications 1 à 5, **caractérisé en ce que** le véhicule virtuel (1*) pour réaliser la marche d'essai est commandé par un chauffeur virtuel en se basant sur un modèle de chauffeur.

7. Procédé selon l'une quelconque des revendications 1 à 5, **caractérisé en ce que** le véhicule virtuel (1*) est commandé par un chauffeur réel pour réaliser la marche d'essai.

8. Procédé selon la revendication 1, **caractérisé en ce que** des données vidéo du parcours (A-B) sont en plus saisies sous la forme d'une séquence de trames vidéo (f) et, lors de la marche d'essai sur le banc d'essai (20), on détecte et l'on représente la trame vidéo (f_{P}) qui correspond à la coordonnée géographique respective (P).

9. Procédé selon la revendication 1, **caractérisé en ce que** des données audio du parcours (A-B) sont en plus saisies et mémorisées en rapport avec les données géographiques et, lors de la marche d'essai sur le banc d'essai (20), on reproduit les données audio qui correspondent à la coordonnée géographique respective (P).

10. Procédé selon la revendication 1, **caractérisé en ce que**, lors de la marche d'essai, les données disponibles (D) ou les données de mesure disponibles (M) sont interrogées pour la coordonnée géographique respective et affichées.

11. Procédé selon la revendication 1, **caractérisé en ce que**, lors du post-traitement de la marche d'essai, des données (D) ou des données de mesure (M) sont recherchées, identifiées et comparées via leur coordonnée géographique (P).
